Europäisches Patentamt

European Patent Office

Office européen des brevets

(11) Publication number : **0 487 240 A2**

# EUROPEAN PATENT APPLICATION

(21) Application number : **91310453.5**

(22) Date of filing : **13.11.91**

(51) Int. Cl.⁵ : **H01L 39/14, H01L 39/24**

(30) Priority : **19.11.90 US 615189**

(43) Date of publication of application :
**27.05.92 Bulletin 92/22**

(84) Designated Contracting States :
**DE FR GB NL**

(71) Applicant : **GENERAL ELECTRIC COMPANY**
**1 River Road**
**Schenectady, NY 12345 (US)**

(72) Inventor : **Rumaner, Lee Evan**
**706 South Avenue**
**Schenectady, New York 12305 (US)**
Inventor : **Jones, Karen Diane**
**20A Lincoln Place**
**New Brunswick, New Jersey 08902 (US)**
Inventor : **Benz, Mark Gilbert**
**11 Parkwood Drive**
**Burnt Hills, New York 12027 (US)**

(74) Representative : **Pratt, Richard Wilson et al**
**London Patent Operation G.E. TECHNICAL**
**SERVICES CO. INC. Burdett House 15/16**
**Buckingham Street**
**London WC2N 6DU (GB)**

(54) **Niobium-tin superconductor.**

(57)    A niobium-tin superconductor is disclosed that is comprised of a niobium alloy core, an outer laminate of a niobium-tin superconducting alloy on the core, and a hafnium oxide precipitate dispersed in the niobium-tin superconducting alloy in an effective amount to increase the current-carrying capacity in the niobium-tin superconductor.

EP 0 487 240 A2

This invention relates to improved niobium-tin superconductor tapes, wires, or strands having improved current-carrying capacity.

It is known that if a body of niobium, either in the pure state or alloyed with a lesser amount of a solute metal, is reacted with tin a layer of an intermetallic compound is formed at the reaction interface which has superconductive properties. These superconductive properties, and specifically the current-carrying capacity may be significantly improved by the inclusion of a dispersion of a second phase therein. In U.S. Patent 3,429,032, it is disclosed that the superconductive properties of niobium-tin superconductors are significantly improved by the formation of a dispersion of stable particles therein which function as flux traps. The flux traps were formed by annealing a tin coated niobium body, comprised of about 1 atomic percent zirconium and the balance niobium, in a select oxidizing atmosphere to diffuse oxygen into the niobium wire and react with the zirconium solute. In British patent 1,254,542, incorporated by reference herein, a niobium wire or tape alloyed with zirconium is treated to provide an oxygen content of 500-5000 parts per million in at least a surface layer of the wire or tape. Tin is deposited over the surface layer on the niobium wire or tape and thereafter heat treated to produce the superconducting niobium-tin alloy.

It is an object of this invention to provide a niobium-tin superconductor having improved current-carrying capacity by the addition of hafnium oxide in the superconducting alloy.

It is another object of this invention to provide the effective amount of hafnium oxide for improving current-carrying capacity in a niobium-tin superconducting alloy.

## Brief Description of the Invention

A niobium-tin superconductor having improved current-carrying capacity is comprised of a niobium alloy core, an outerlaminate of a niobium-tin superconducting alloy on the core, and a hafnium oxide precipitate dispersed in the niobium-tin superconducting alloy in an effective amount to increase the current-carrying capacity in the niobium-tin superconductor.

## Detailed Description of the Invention

The niobium-tin superconductor of this invention can be formed by providing a niobium alloy body, for example wire or tape, comprised of hafnium as a solute metal and the balance substantially niobium. As used herein, the term "balance substantially niobium" means the remainder of the alloy is substantially niobium and may include amounts of other elements, such as up to about 5 atomic percent zirconium, molybdenum, uranium, or rhenium that do not substantially impair the mechanical or superconducting properties of the niobium-tin superconductor. Hafnium is present in an amount from 0.5 to 5 atomic percent, preferably about 1 to 2 atomic percent.

The niobium alloy body is treated to introduce up to about 10 atomic percent oxygen into the body. Anodization is a preferred means for oxidizing the surfaces of the alloy bodies, but any other functionally equivalent method for controllably oxidizing the surfaces can be used. The oxide film on the oxidized body must be substantially entirely decomposed to provide a substantially oxide-free, clean surface so that molten tin will wet the surface as an adherent continuous layer.

An amorphous niobium oxide is formed by the anodization, comprised of about $Nb_2O_5$, and it has been observed that temperatures above about 700°C are required for the decomposition of $Nb_2O_5$ to occur at acceptable rates. At temperatures in excess of about 1200°C, the amorphous nature of the anodized oxide coating is changed in whole or in part to a crystalline layer which decomposes at a slower rate. It is, therefore, desirable to heat treat at as high a temperature as is convenient without producing substantial amounts of crystallinity. The heat treatment is performed in a non-oxidizing atmosphere, such as argon.

The heat treated niobium-base alloy body is tin coated in a bath operated in the temperature range of about 800°-1200°C, preferably at about 1000°C. The tin coating bath may contain up to about 40 weight percent, preferably about 10 weight percent copper, up to about 10 weight percent lead, and up to about 10 weight percent indium or combinations thereof.

A final heat treatment to react the tin layer with the niobium substrate is preferably accomplished in the range of about 850°-1200°C, preferably at about 1050°C in a non-oxidizing atmosphere such as argon.

While the foregoing description has involved the separate operating steps of oxide coating the body, annealing to dissociate the oxide, tin coating, and heat treating to produce the intermetallic compound, it will be readily apparent to those skilled in the art that several of these steps may be accomplished in one piece of apparatus. For example, a molten tin bath may be used to combine the annealing or oxide dissociation step with the tin coating step. Since the oxide dissociation is a time-temperature dependent reaction, the first part of the exposure of the niobium alloy body to the tin bath functions to decompose the oxide film and the latter functions to tin coat the body. If the body is maintained longer in the tin bath, the intermetallic compound may also be formed on the exposed surfaces of the body.

Example 1

Niobium foil tape containing about 1.17 atomic percent zirconium, and niobium foil tape containing about 1 atomic percent hafnium as solutes were treated as follows The tapes were about 25.4 millimeters in width by 0.025 millimeters in thickness, and were anodized by passing through an aqueous bath composed of about 7 grams per liter of sodium sulfate which was maintained at 25°C, utilizing a stainless steel cathode. At 25°C, the anodizing bath produced about 22 angstroms of $Nb_2O_5$ per volt. A potential voltage was applied between the tape as the anode and the stainless steel cathode to introduce a desired atomic percent of oxygen into the tape as an oxide coating.

The anodized tape was then heat treated by passing it through an argon atmosphere tube furnace having a heating zone about 3 feet long at a rate of 2.0 feet per minute at a temperature of 1000°C. During this heat treatment, the $Nb_2O_5$ was decomposed to metallic niobium and the oxygen diffused into the body of the tape.

The substantially oxide-free surfaces of the tape were then contacted with molten tin by passing the tape through a tin bath comprised of about 14 weight percent copper and the balance tin, at a temperature of 1050°C at a rate of 14 feet per minute to produce an adherent continuous film of tin-copper alloy on the tape surfaces which amounted to 1.0 grams per foot. The coating of tin-copper alloy is herein referred to as a tin coating. The tin coated tape was then heat treated in an argon atmosphere tube furnace at 1050°C for about 200 seconds.

The critical current of the superconductive tape was conventionally measured at 4.2 K in a field of 5 Tesla. The anodizing voltage, atomic percent oxygen dissolved, thickness of niobium tin superconductive alloy formed on each side, and measured current density of several of the best tape samples produced according to the processing described above, is shown below in Table 1.

## Table 1

### Oxygen Content and Critical Current Measured in $Nb_3Sn$ Tape with Zr or Hf Addition

| Sample No. | Solute Atomic Percent | Anodizing Voltage | Oxygen Atomic Percent | $Nb_3Sn$ Film (Microns) | Current Density $J_c$ (A/cm$^2$) |
|---|---|---|---|---|---|
| 1 | Zr 1.17 | 70 | 1.61 | 6.85 | 8.22 |
| 2 | Zr 1.17 | 90 | 1.87 | 8.19 | 7.59 |
| 3 | Zr 1.17 | 110 | 2.28 | 9.16 | 9.55 |
| 4 | Zr 1.17 | 130 | 2.59 | 10.95 | 8.63 |
| 5 | Hf 1.0 | 40 | 1.05 | 5.10 | 6.43 |
| 6 | Hf 1.0 | 60 | 1.40 | 5.60 | 10.46 |
| 7 | Hf 1.0 | 80 | 1.78 | 5.70 | 9.31 |

Upon examination, it was found that this treatment produced a total thickness, i.e. both sides, of about 10-20 microns $Nb_3Sn$ while about 6-15 microns of unreacted niobium remained as a core portion, and about 1 micron of tin coating remained on the surface. The maximum thickness achievable in the zirconium alloyed $Nb_3Sn$ tape occurred when the oxygen content was about that necessary stoichiometrically to completely oxidize all the zirconium dissolved in the niobium based alloy to produce a dispersion of zirconium oxide particles. When the oxygen content was less than, the stoichiometric amount, the properties were less than optimum and when it was greater, the properties also declined. Unexpectedly, in the 1 atomic percent hafnium alloyed $Nb_3Sn$ superconducting tape, the critical current was highest when the amount of dissolved oxygen was about 1.4 atomic percent. The useful limits of oxygen appeared to be between about 1.1 to 1.8 atomic percent, preferably between about 1.3 to 1.5 atomic percent for the niobium tape comprised of 1 atomic percent hafnium.

Sample No. 6 above, was analyzed by transmission electron microscopy. Particles of hafnium oxide, predominantly $HfO_2$, were found dispersed throughout the $Nb_3Sn$ superconductor both within the grains and between grains in the grain boundaries. As shown by the current densities measured above, the 1 atomic percent hafnium alloyed niobiumtin superconductor has improved current density over the 1 atomic percent zirconium alloyed $Nb_3Sn$ superconductor.

**Claims**

1.  A niobium-tin superconductor consisting essentially of, a niobium alloy core, an outerlaminate of a niobium-tin superconducting alloy on the core, and a hafnium oxide precipitate dispersed in the niobium-tin superconducting alloy in an effective amount to increase the current-carrying capacity in the niobium-tin superconductor.

2.  The niobium-tin superconductor of claim 1 having up to about 5 atomic percent hafnium oxide precipitate.